# EUROPEAN PATENT APPLICATION

(11) **EP 1 251 530 A2**
(43) Date of publication of application: **23.10.2002**
(21) Application number: 02252632.1
(22) Date of filing: 15.04.2002
(51) Int. Cl.: H01G 4/30

(54) **Dielectric laminate for a capacitor**

(30) Priority: 16.04.2001 US 284106 P
(71) Applicant: Shipley Company LLC, Marlborough, MA 01752 (US)
(72) Inventor: Knudsen, Philip D., Northboro, Massachusetts 01532 (US); Allen, Craig S., Lower Gwynedd, Pennsylvania 19002 (US)
(74) Representative: Kent, Venetia Katherine

(57) **Abstract**

A dielectric composed of a core material between two polymer layers that have permittivity values less than the core material. The polymer layers provide structural integrity for the dielectric. The dielectric can be employed in a capacitor to fine tune the capacitance of the capacitor. The dielectric and the capacitor may have a thickness in the micron range.

Accordingly, the dielectric and capacitor provide for the miniaturization of electronic devices.

The dielectric may be employed in decoupling capacitors to reduce noise in electronic devices.

## Description

The present application claims the benefit of U.S. provisional application number 60/284106 filed April 16, 2001, which is incorporated by reference herein in its entirety.

### Background of the Invention

The present invention is directed to a dielectric laminate for a capacitor. More specifically, the present invention is directed to a dielectric laminate having a core dielectric material between layers of lower permittivity polymer material that may be employed in a capacitor.

There is an increasing demand for a flexible, tunable and reliable high dielectric that may be employed for a variety of applications in electronic circuitry design and manufacture industries. The need for such dielectrics is especially in great demand in the printed wiring board (PWB) industry where such dielectric materials are crucial for future improvements in PWB design.

Printed wiring boards have long been formed as laminated structures upon which large numbers of devices such as integrated circuits are mounted or formed for use in a wide variety of electronic applications. Such printed wiring boards have been formed with internal power and ground planes, or conductive sheets, the various devices including traces or electrical connections with both the power and ground planes for facilitating their operation.

Substantial effort has been expended in the design of such PWBs and the device arranged thereupon to compensate for voltage fluctuations arising between the power and ground planes in PWBs, particularly for sensitive devices such as integrated circuits mounted or formed on the board surface and connected with both the power and ground planes for operation. Such voltage fluctuations are caused by the integrated circuits switching on and off. The voltage fluctuations cause "noise" that is undesirable and/or unacceptable in many applications.

A solution to the noise problem has been the provision of surface capacitors connected directly with the integrated capacitors connected directly with the integrated circuits in some cases and connected with the power and ground planes in the vicinity of the selected integrated circuit in other cases. The surface capacitors were formed or mounted upon the surface of the PWB and connected with the respective devices or integrated circuits either by surface traces or by through-hole connections, for example.

Surface capacitors have been found effective to reduce or to smooth the undesirable voltage fluctuations referred to above. However, surface or bypass capacitors have not always been effective in all applications. For example, the capacitors themselves tend to affect "response" of the integrated circuits or other devices because they have not only a capacitive value but an inductive value as well. Workers in the art know well that inductance arises because of currents passing through conductors such as the traces or connectors coupling the capacitors with the devices or power and ground planes.

Furthermore, as noted above, the integrated circuits or other devices are a primary source of radiated energy creating noise from voltage fluctuations in the printed wiring boards. Different characteristics are observed for such devices operating at different speeds or frequencies. Accordingly, PWBs and device arrays as well as associated capacitors are designed to reduce noise at both high and low speed operations.

The design of printed wiring boards and device arrays for trying to overcome the above discussed problems are well known to those skilled in the art of printed wiring board design. Use of surface mounted capacitors that are individually connected with the integrated circuits or devices substantially increase the complexity and cost of manufacture of PWBs as well as undesirably affecting PWB reliability. Thus, there is a continuing need in the PWB industry for further improvements in the design of capacitors to overcome many or the above-mentioned problems.

U.S. Pat. No. 4,853,827 to Hernandez discloses a capacitor that allegedly has a high capacitance, a low inductance, and a low equivalent series resistance (ESR). Such a capacitor is perceived in applications such as noise suppression in high current power distribution systems for digital computers, telecommunications modules, AC ripple filtering in DC power supplies and the like. The dielectric material that composes the capacitor is a ceramic material such as BaTiO₃, magnesium niobate, iron tungsten niobate and the like. The dielectric material is in the shape of chips, pellets or sheets that are arranged in a planar array. Spaces between the dielectric are filled with a flexible polymer/adhesive to form a sheet with the polymer binding the array of dielectric material. Thus, polymeric material contacts only the sides of the pellets, chips or sheets and is out of contact with the top and bottom surfaces of the dielectric. The polymers that are employed include polyetherimides, polyimides, polyesters and epoxies. The exposed surfaces of the dielectric and polymer are metallized with a thin metal layer of from about 10-50 microinches. The thin metal layer may then be plated up to higher thicknesses of about 1-2 mils. Capacitance of the capacitor is controlled by the distance between the metal layers or electrodes and the number of dielectric pellets.

A disadvantage of the capacitor of the '827 patent is the thickness of the capacitor. The capacitor has a thickness of about 0.005-0.015 inches (0.013-0.038 centimeters). The larger the capacitor the more space the capacitor occupies on the PWB leaving less room for other board components. Thus, PWBs necessarily are made large enough to accommodate the necessary board components. Limiting the size of boards means that the electronic industry is limited to how compact or small electronic devices can be made. The industry as a whole is geared to developing electronic equipment that is compact, and operates at an equivalent caliber or better than a larger counterpart. Another disadvantage to a relatively thick capacitor is that as the distance between two electrodes increases, the capacitance decreases. As the electronics industry gears electronic devices to miniaturization with increased computing power thinner capacitors with higher capacitance are required. Thus a thinner capacitor than the '827 capacitor is highly desirable.

U.S. Pat. No. 6,068,782 to Brandt et al. discloses embedded capacitors that are integral components of a PWB or a multichip module. Such a design permits the removal of passive components, i.e., capacitors, from the PWB surface and their integration into a multilayer board to provide miniaturization and increased computing power of the electronic devices. Other benefits are improved environmental stability and reduced system noise and noise sensitivity due to shortened leads. Examples of such embedded passive components are decoupling or bypass capacitors. Particularly at high frequencies, such functions are often difficult or impractical to perform by passive through-hole or surface-mount components located on the board surface. The embedded capacitor disclosed in the '782 patent is formed in situ on the substrate or PWB. A capacitor bottom electrode and other circuitry is formed onto a suitable substrate followed by applying a first patternable insulator; patterning of the insulator to define location, area and height of a capacitor dielectric, and development of the pattern; depositing a capacitor dielectric into the pattern; and then creating a capacitor top electrode and other circuitry on top of or in the patterned layer. Thus the capacitor has a sandwich structure with a capacitor dielectric core between two electrodes. The thickness of the dielectric allegedly ranges from 0.1µm to 100µm. The capacitor is electrically connected to the same and/or other PWB layers.

Capacitor dielectrics of the '782 patent include a polymer, a polymer/ceramic (metal oxide) composite or a ceramic (metal oxide). The capacitor dielectric may also be formed from more than one layer of different capacitor dielectric materials to tune the electronic properties of the capacitor component. However, tuning the electric properties of a capacitor having a dielectric layer of a polymer/ceramic (metal oxide) composite to a desired value is difficult and uncertain. For example, the permittivity of the composite dielectric is a combination of the permittivity of the polymer and the ceramic. Such a permittivity of a composite is at best an approximation. A more accurate permittivity value is highly desirable to obtain a more accurate capacitance. When the capacitance of a capacitor is accurately known, the capacitor may be employed to function optimally at the frequency ranges desired in an electronic device. Accordingly, the electronic device in which the capacitor is employed also operates more effectively.

Another disadvantage of the capacitor in the '782 patent is the in situ method by which the capacitor is made. By preparing the capacitor in situ, additional steps are added to the manufacture of the PWB or multilayer PWB reducing efficiency of PWB manufacture. Further, thickness of the capacitor dielectric is determined by the first paternable insulator layer and the solvent content of the capacitor dielectric. Capacitor dielectric material is deposited on the PWB in a solvent. The solvent is evaporated during thermal processing causing the capacitor dielectric to shrink to a thickness to obtain a capacitance. Such a method of driving off solvent is an unreliable means for obtaining a specific thickness for a dielectric. A worker in the art can not accurately gauge the specific amount of solvent to drive off to obtain the desired thickness for a desired capacitance.

Additionally, the '782 patent admits that depositing a thin film capacitor dielectric from a liquid to obtain a controlled thickness on a substrate is very difficult, if not impossible. Materials that compose substrates, such as PWBs, suffer from inherent warpage and thickness variations. Also, doctor-blades used to apply the dielectric tend to bend and scoop more dielectric material in the middle than at the edges of a patterned insulator. In an effort to overcome such problems, the method limits the site of the capacitor to a small area. Alternatively, a grid over a large area is provided that keeps the blade at a defined distance from the PWB. Such a method is both tedious and inefficient.

EP 1 005 260 A2 of Microcoating Technologies Inc. discloses a thin film embedded capacitor and method of making the capacitor by combustion chemical vapor deposition (CCVD) or by controlled atmosphere combustion chemical vapor deposition (CACCVD). The capacitors may be embedded in printed wiring boards but do not have to be prepared in situ on the board as in Brandt et al. described above. The capacitors may be employed as decoupling capacitors to help eliminate "noise" by maintaining square electrical signals.

The CCVD process permits the formation of thin film uniform layers in an open atmosphere without any costly furnace, vacuum, or reaction chamber. The CCVD process may form layers with a thickness of less than 500 nm. Such thin film uniform layers are highly desirable because the thinner the layers of the capacitor the higher the capacitance. Also, the loss is increased. Lossy dielectrics have a desirable electrical conductivity of from about 10⁻¹ to about 10⁻⁵ amperes per cm². Such thin film capacitors enable further minaturization of printed wiring boards.

When an oxygen free environment is needed for uniform thin film formation, CACCVD is employed instead of CCVD. CACCVD employs non-combustion energy sources such as hot gases, heated tubes, radiant energy, microwave and energized photons. In CACCVD applications all liquids and gases used are oxygen free.

The capacitors are flexible such that they are capable of being bent around a six-inch radius. Dielectric material includes ceramic materials (metal oxides) that are deposited on a substrate by CCVD or by CACCVD. In one embodiment the capacitor is composed of successive deposition layers on a polymeric support sheet such as a polyamide sheet. A metal layer of nickel or copper is deposited by CACCVD on a polyamide sheet. A dielectric layer is then deposited thereon, and a second metal layer is then deposited by CCVD, CACCVD or by electroplating. The capacitor may be employed as a decoupling capacitor, or the second metal layer may be patterned to produce discrete capacitor plates by a suitable photoresist/etching process. The metal layers of the capacitor are from about 0.5 to about 3 microns thick. The dielectric layer ranges from about 0.03 to about 2 microns thick.

Dielectric materials employed are silica and silica-based compositions, including 100% silica layers, amorphous and crystalline, but also doped silica and silica mixed with other oxides such as PbO, Li₂O, K₂O, Al₂O₃, and B₂O₃. The dielectric materials also may be doped with a variety of elelments such as Pt, B, Ba, Ca, Mg, Zn, Li, Na, K, and the like. Other dielectric materials employed in the core dielectric include BST, SrTiO₃, Ta₂O₅, TiO₂, MnO₂, Y₂O₃, SnO₂, barium titanium oxide (Ba₂Ti₉O₂₀), tin-doped barium titanium oxide (Ba₂Ti₁₋₍₉₋ₓ₎Snₓ₋₈O₂₀; X>0) and zirconium-doped barium titanium oxide (Ba/Ti₁₋₍₉₋ₓ₎Zrₓ₋₈O₂₀); X>0). Such dielectric materials have high permittivity, thereby permitting capacitors of small size to provide high capacitance.

The foregoing materials may be deposited as thin layers on a substrate by the CCVD process by appropriate selection of chemical reagents or precursors in a precursor solution. The dielectric layer may have layers of different composition. For example, a multi-layer film can be of alternating layers of silica and lead silicate, a dual layer composed of a lead silicate base with a top coat of lead aluminum boron silicate, or a composite gradient film of silica to doped silica to lead silica. The multi-layers may be deposited by varying the content of the precursor solution that is fed to a flame or by moving the substrate to successive deposition stations where layers of different composition are deposited.

Copper is a highly desirable substrate and metal for use with embedded capacitors. However, copper melts at 1083° C thus deposition on copper is limited to materials that can be deposited by CCVD at lower temperatures. Materials that are deposited at temperatures of upwards of about 1000° C can not be deposited on copper, but must be deposited on a substrate that melts at a higher temperature. Highly desirable dielectric materials such as barium strontium titanate (BST) have melting points of upward of about 1350° C and can not be deposited by CCVD on copper and crystallize to the desired dielectric material. Examples of other materials that are not suitable for deposition on copper by CCVD include oxide and mixed oxide phases that contain Ti, Ta, Nb, Zr, W, Mo, or Sn. To obtain the desired crystalline structure, BST must be deposited on a substrate with a higher melting point.

Additionally, copper has a relatively high coefficient of linear thermal expansion, considerably higher than many high permittivity dielectric materials such as BST, barium titanium oxide, zirconium-doped barium titanium oxide, and tin-doped barium titanium oxide. A substantial mismatch in thermal expansion coefficients between a substrate and a CCVDdeposited film that is deposited at a temperature higher than the substrate may result in the deposited substrate cracking during cooling. Preferably, metal substrates for CCVD deposition have coefficients of linear thermal expansions below about 15 ppm°C⁻¹, more preferably below about 12 ppm°C⁻¹. To avoid cracking of the film, the coefficient of linear thermal expansion of the substrate is no more than about 80% above that of the material to be deposited. Preferably the coefficient of linear thermal expansion is no more than about 40% above that of the material to be deposited and most preferably no more than about 20% above that of the material to be deposited. The closer the coefficient of thermal expansion, the thicker the coating material can be deposited and/or the higher the deposition temperature may be without cracking the coating.

Specific metals and alloys that may serve as high-temperature or low thermal expansion substrates include nickel, tungsten, iron, niobium, molybdenum, titanium, nickel/chromium alloy, and iron/nickel/chromium alloy, such as that sold under the trademark Inconel®. Such materials can withstand higher temperatures than copper. Thus higher temperature dielectric materials such as BST and lead lanthanum zirconium titanate may be deposited on such metals. The higher melting points of the aforementioned metals enable depositions of various materials not depositable on copper and the lower thermal expansion prevents the layer from cracking due to thermal expansion mismatch.

To employ copper or another low melting temperature material such as aluminum or a polymer such as polyimide with the higher melting temperature dielectric materials, a barrier layer may be employed to protect the low melting temperature substrate. Barrier layer material can be deposited as dense, adherent coatings at temperatures of about 700° C or below gas temperature. The substrate temperature during deposition is about 200 to 500 degrees lower than the barrier layer material. Depositing the barrier layer material at low temperatures reduces the effect of thermal expansion mismatch and the potential of oxidizing the metal substrate and deforming/degrading a polymer substrate. The barrier layer also may be a ceramic material that functions as a dielectric along with the ceramic material deposited as the dielectric layer. The barrier layer may be composed of tungsten oxide (WO₃), strontium oxide (SrO), mixed tungsten strontium oxides such as SrWO₄, BaWO₄, CeO₂, and Sr₁₋ₓBaₓWO₄. After depositing the dielectric layer on the barrier layer, a thin metal layer may be deposited on the dielectric layer. An adhesion layer may be deposited between the dielectric layer and the deposited metal layer. The adhesion layer helps bind the thin metal layer to the dielectric material. The adhesion layer may be composed of a conductive oxide such as zinc oxide. The adhesion layer also may be a functionally gradient material (FGM) layer in which the composition changes throughout the adhesion layer. For example, silica-to-platinum adhesion may be promoted by a silica/platinum adhesion layer that changes incrementally or continuously in composition from high silica content at the silica side to high platinum content at the platinum side. In general, a material that contains elements common with the two layers between which it is interposed acts to promote adhesion. A capacitor may contain only a barrier layer or only an adhesion layer as is necessitated by construction constraints. Alternatively, an adhesion and barrier layer may be needed on both sides of the dielectric.

The dielectric layer ranges from about 0.03 to about 2 microns. The barrier layer ranges from about 0.01 to about 0.08 microns, and the adhesive layer ranges from about 0.001 to about 0.05 microns. Deposited thin metal layers range from about 0.5 to about 3 microns thick.

Although there is a thin film capacitor and method of making the same that allows for the miniaturization of printed wiring boards, there is still a need for improved dielectrics that are flexible and enable fine tuning the capacitance of a capacitor.

### Summary of the Invention

The present invention is directed to a dielectric laminate having a core dielectric material between two layers of polymer dielectric materials that have lower permittivity values than the core dielectric material. Advantageously, the structure of the dielectric laminate with a core dielectric material between dielectric polymer layers permits accurate or fine tuning of the dielectric to a desired permittivity. The dielectric having the desired permittivity may then be employed in a capacitor structure to fine tune the capacitor to a desired capacitance. The polymer layers provide sufficient support for the dielectric such that the dielectric is self-supporting and may be prepared separate from a substrate on which the dielectric may be employed. Thus a dielectric with a desired permittivity may be prepared as a bulk laminate or sheet. The dielectric laminates of the present invention may be thin film dielectric laminates that enable miniaturization of substrates such as printed wiring boards.

Dielectric laminates of the present invention are prepared by laying down a layer of a core dielectric material on a polymer layer followed by laying down another polymer layer on the core dielectric material to form a laminated dielectric. The core dielectric may contain one or more layers of laminated dielectric material having the same or a different permittivity to obtain a desired core permittivity. Advantageously, the thickness of each layer, both the polymer layers and the core dielectric layers, may be readily controlled during lamination to tune the dielectric to a desired permittivity. The polymer layers stabilize the dielectric such that the dielectric is self-supporting and may be rolled upon itself without cracking or breaking. Additionally, polymer thickness assists in fine tuning capacitor capacitance. Advantageously, a dielectric laminate can be prepared with a finely tuned desired permittivity, and stored in bulk for future use. An aliquot having a desired permittivity and thickness can be punched or cut from the bulk sheet with desired dimensions and then employed in a capacitor to finely tune the capacitor to a desired capacitance. The dielectric laminates of the present invention may be laminated to metal electrodes or metal electrodes may be plated onto the polymer layers.

Advantageously, the dielectric laminates of the present invention need not be made during printed wiring board manufacturing process steps. Such additional steps in printed wiring board processes reduce the overall efficiency of board manufacture.

The dielectric laminate may be placed on a substrate such as a wiring board at a specific site or the dielectric laminate may cover the entire surface of the printed wiring board. The dielectric laminate may be etched, or a metal electrode layer covering the dielectric may be etched as desired. The dielectric of the present invention may be employed in multi-layer circuit board constructions where the dielectric may be employed in an embedded capacitor. Capacitors of the present invention may be employed as capacitors in various electronic devices such as in digital computers, telecommunication modules, AC ripple filtering in DC power supplies and the like. Such capacitors may be bypass capacitors or decoupling capacitors, and the like.

An objective of the present invention is to provide a dielectric laminate having a core dielectric material between two polymer layers having lower permittivity values than the core dielectric.

Another objective of the present invention is to provide a dielectric laminate where the permittivity can be accurately tuned.

A further objective of the present invention is to provide a dielectric laminate that is flexible and self-supporting.

An additional objective of the present invention is to provide a thin film dielectric laminate.

Still yet a further objective of the present invention is to provide a dielectric laminate that can be employed in an embedded capacitor.

Additional objectives and advantages of the present invention may be readily ascertained by those of skill in the art after reading the detailed disclosure and the appended claims.

### Brief Description of the Drawings

Figure 1 is a cross-sectional view of a three layer dielectric having a core ceramic material between two polymer layers of lower permittivity than the ceramic core.
Figure 2 is a cross-sectional view of a five layer capacitor having a core ceramic material two polymer layers of lower permittivity than the ceramic and a top and bottom metal layer.
Figure 3 is a cross-sectional view of a six layer capacitor having two layers of core ceramic material with different permittivities between two polymer layers of lower permittivities than the core ceramic materials and a top and bottom metal layer.
Figure 4 is a cross-sectional view of a polymer layer and a CCVD deposited higher permittivity material illustrating texturing at the interface between the polymer layer and the deposited higher permittivity material.
Figure 5 is a schematic diagram of a CCVD apparatus that may be employed to deposit thin film layers on a substrate.
Figure 6 is a schematic diagram of a CACCVD apparatus that may be employed to deposit thin film layers on a substrate.
Figure 7 is a cross-sectional view of a FR-4 epoxy/glass wiring board containing a capacitor laminated to the board.
Figure 8 is a cross-sectional view of a FR-4 epoxy/glass wiring board containing two capacitors formed by an etching process, and laminated to the board.

### Detailed Description of the Invention

The present invention is directed to a dielectric composed of a core dielectric material between two polymer layers that have permittivity values less than the core dielectric material. The dielectric of the present invention may be employed in a capacitor. Advantageously, the arrangement of a core dielectric material with a higher permittivity between two polymer layers of lower permittivities enables the dielectric permittivity of the entire dielectric to be readily tuned to an accurate permittivity value. Additionally, by tuning the dielectric to an accurate permittivity, the capacitance of the capacitor in which the dielectric is employed also may be tuned to an accurate value. Dielectrics of the present invention are self-supporting. The polymer sandwich arrangement provides sufficient structural support such that the dielectric laminates need not be prepared in situ or prepared on or in the substrate in which the dielectric laminates are employed.

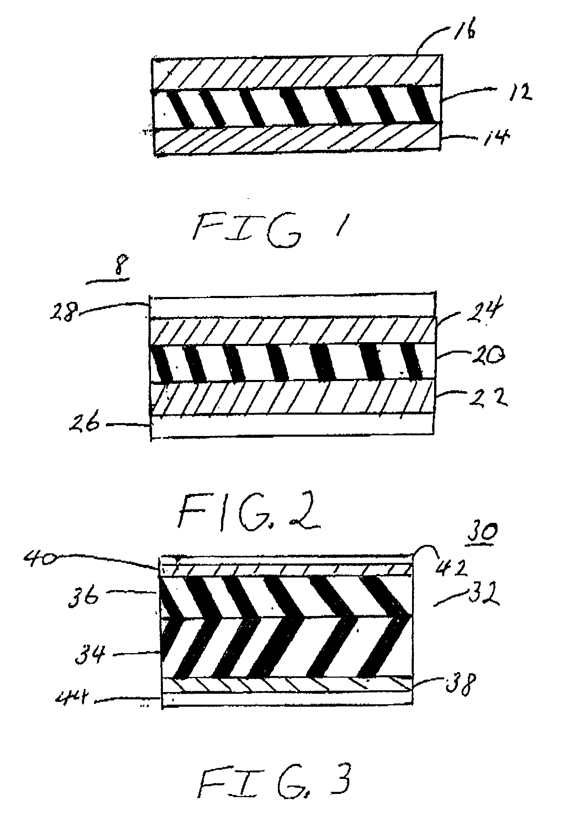

Figure 1 illustrates a dielectric laminate 10 of the present invention. A dielectric core layer 12 is bonded to a dielectric polymer support layer 14. A second dielectric polymer support layer 16 is then bonded to the dielectric core 12. Each layer may be prepared separately and then bonded to the other layers. Alternatively, each layer may be prepared in sequence, i.e., one layer deposited upon a previous layer. Advantageously, the layers of the dielectric laminate may be prepared without an additional adhesive layer to bind the dielectric layers together. Further, the layers of the dielectric laminate may be prepared without a barrier layer. The absence of such layers enables a more accurate tuning of the permittivity of the entire dielectric composition. Thus, undesired layers that may interfere with tuning a dielectric to a specific permittivity are eliminated. Methods by which the layers may be prepared are discussed below.

Any material that can be employed as a dielectric and that has a permittivity or dielectric constant higher than the polymer layers may be employed to practice the present invention. Such materials have high permittivity values in contrast to polymer materials. Permittivity values for core materials range from at least about 20. Preferably, the permittivity of the core ranges from about 20 to about 100,000. Most preferably, the permittivity of the core ranges from about 50 to about 50,000.

Examples of suitable materials that may be employed as core dielectric materials include, but are not limited to, carbon compounds such as diamond, and ceramic materials such as silicon carbide, silica and silica based compositions, including 100% silica layers, amorphous and crystalline, but also doped silica and silica mixed with other oxides, such as PbO, Na₂O, Li₂O, K₂O, Al₂O₃ and B₂O₃. Other suitable ceramic materials include, but are not limited to, barium strontium titanate (BST), SrTiO₃, Ta₂O₅, TiO₂, MnO₂, Y₂O₃, PbZrTiO₃ (PZT), LiNbO₃, PbMgTiO₃ (LMT), PbMgNbO₃ (LMN), CeO₂, barium titanium oxide, tungsten oxide, mixed tungsten strontium oxides such as SrWO₄, BaWO₄, and tungsten strontium barium oxides and the like.

Core dielectric materials also may be doped with a variety of elements such as Pt, B, Ba, Ca, Mg, Zn, Li, Na, K, Sn, Zr, and the like. Examples of such doped core dielectrics include, but are not limited to, zirconium-doped barium titanium oxide, tin-doped barium titanium oxide, and the like. The dielectric of the present invention may have one or more layers of such high permittivity material to compose the core and tune the permittivity value of the dielectric. For example, the core layer may contain two layers of different high permittivity material or from 3 to 5 layers of different high permittivity material to tune the dielectric laminate. The thickness of each layer of high permittivity material also may vary as desired to properly tune the dielectric layer. Also, the different high permittivity materials may be blended as desired to obtain a desired permittivity value for the core.

Any polymer that may be laminated to a surface may be employed to practice the present invention. Polymers within the scope of the present invention include both organic polymers and inorganic polymers. Permittivity values of the polymers range from about 1 to about 15. Preferably, the permittivity values of the polymers range from about 3 to about 10. Preferably, the polymers employed also are flexible. Examples of such organic polymers include, but are not limited to, thermoplastic, thermosetting, addition and condensation polymers. Illustrative examples include, but are not limited to, polyesters, polystyrene, high impact polystyrene, styrene-butadiene copolymers, impact modified styrene-butadiene copolymer, poly-α-methyl styrene, styrene acrylanitrile copolymers, acrylonitrile butadiene copolymers, polyisobutylene, polyvinyl chloride, polyvinylidene chloride, polyvinyl acetals, polyacrylonitrile, alky polyacrylates, alky polymethacrylates, polybutadiene, ethylene vinyl acetate, polyamides, polyimides, polyoxymethylene, polysulfones, polyphenylene sulfide, polyvinyl esters, melamines, vinyl esters, epoxies, polycarbonates, polyurethanes, polyether sulfones, polyacetals, phenolics, polyester carbonate, polyethers, polyethylene terephthalate, polybutylene terephthalate, polyarylates, polyarylene ethers, polyarylene sulfides, polyether ketones, polyethylene, high density polyethylene, polypropylene, and copolymers, grafts, blends, and mixtures thereof. Polymers employed as dielectric layers may have high T_{g} ranges. High T_{g} within the scope of the present invention is from at least about 90° C. Preferably, the T_{g} is at least about 100° C, preferably at least about 130° C. A preferred range is from about 130° C to about 190° C. Such T_{g} polymers provide both mechanical and heat stable dielectrics during the operation of electronic devices in which the dielectrics are employed. Additionally, such high T_{g} polymers withstand high temperature conditions during lamination of core dielectrics and metal electrodes. Polyurethanes are examples of polymers with a high T_{g}. A photosensitive polymer such as a dry film photoresist may be employed such that the polymer may be imaged to a desired pattern. Such dry films include, but are not limited to, polyurethanes, epoxy resins, copolymers, blends, or mixtures thereof. A preferred organic polymer is a polymer with aromatic groups. Preferably, such dry film photoresists are cross-linked with acrylate, methacrylate or propylacrylate oligomers having a molecular weight of from about 100 D (daltons) to about 5,000 D, preferably from about 500D to about 1,000 D. Oligomers within the scope of the present invention are composed of from 2 to 100 monomers. Other preferred crosslinkers are acrylated urethanes having molecular weights of from about 500 D to about 100,000 D, preferably from about 1,000 D to about 50,000 D.

Other suitable cross-linkers that may be employed to cross-link polymers employed in the present invention include di-, tri, tetra-, or higher multifunctional ethylenically unsaturated monomers. Examples of cross-linkers useful in the present invention are trivinylbenzene, divinylbenzene, divinylpyridine, divinylnaphthalene, and divinylxylene; and such as ethyleneglycol diacrylate, trimethylolpropane triacrylate, diethyleneglycol divinyl ether, trivinylcyclohexane, allyl methacrylate (ALMA), ethyleneglycol dimethacrylate (EGDMA), diethyleneglycol dimethacrylate (DEGDMA), propyleneglycol dimethacrylate, propyleneglycol diacrylate, trimethylolprapane trimethacrylate (TMPTMA), divinyl benzene (DVB), glycidyl methacrylate, 2,2-dimethylpropane 1,3 diacrylate, 1,3-butylene glycol diacrylate, 1,3-butylene glycol diacrylate, 1,3-butylene glycol dimethacrylate, 1,4-butanediol diacrylate, diethylene glycol diacrylate, diethylene glycol diacrylate, diethylene glycol dimethacrylate, 1,6-hexanediol diacrylate, 1,6-hexanediol dimethacrylate, tripropylene glycol diacrylate, triethylene glycoldimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaerythritol monohydroxypentaacrylate, divinyl silane, trivinyl silane, dimethyl divinyl silane, divinyl methyl silane, methyl trivinyl silane, diphenyl divinyl silane, divinyl phenyl silane, trivinyl phenyl silane, divinyl methyl phenyl silane, tetravinyl silane, dimethyl vinyl disiloxane, poly(methyl vinyl siloxane), poly(vinyl hydro siloxane), poly(phenyl vinyl siloxane) and mixtures thereof.

Another preferred organic polymer is a polymer that contains butadiene. Examples of such polymers include, but are not limited to, polybutadiene, styrene-butadiene copolymers, impact modified styrene-butadiene copolymers, acrylonitrile butadiene, and the like. Other preferred polymers are phenolics such as phenol aldehyde condensates (known in the art as novolak resins), partially hydrogenated novolak and poly(vinylphenol) resins.

Novolak resins are thermoplastic condensation products of a phenol and an aldehyde. Examples of suitable phenols for condensation with an aldehyde, especially formaldehyde, for the formation of novolak resins, include phenol; m-cresol; o-cresol; p-cresol; 2,4-xylenol; 2,5-xylenol; 3,4-xylenol; 3,5-xylenol; thymol and mixtures thereof. An acid catalyzed condensation reaction results in the formation of a suitable novolak resin that may vary in molecular weight from about 500 to about 100,000 D.

Poly(vinylphenol) resins are thermoplastic materials that may be formed by block polymerization, emulsion polymerization or solution polymerization of corresponding monomers in the presence of a cationic catalyst. Vinylphenols used for production of poly(vinylphenol) resins may be prepared, for example, by hydrolysis of commercially available coumarins or substituted coumarins, followed by decarboxylation of the resulting hydroxy cinnamic acids. Useful vinyl phenols may also be preppared by dehydration of the corresponding hydroxy alkyl phenol or by decarboxylation of hydroxy cinnamic acids resulting from the reaction of substituted or non-substituted hydroxy benzaldehydes with malonic acid. Preferred poly(vinylphenol) resins prepared from such vinyl phenols have a molecular weight range of from about 2,000 to about 100,000 D. Procedures for the formation of poly(vinylphenol) resins also can be found in U.S. Pat. No. 4,439,516, the entire disclosure of which is hereby incorporated herein in its entirety by reference. Many useful poly(vinylphenol) resins are commercially available from Mauruzen Corporation of Tokyo, Japan.

Cross-linking agents that may be employed with novolak and poly(vinylphenol) resins include, but are not limited to, amine containing compounds, epoxy containing materials, compounds containing at least two vinyl ether groups, allyl substituted aromatic compounds, and combinations thereof. Preferred cross-linking agents include amine containing compounds and epoxy containing materials.

Amine containing cross-linkers include, but are not limited to, melamine monomers, melamine polymers, alkylolmethyl melamines, benzoguanamine resins, benzoguanamineformaldehyde resins, urea-formaldehyde resins, glycoluril-formaldehyde resins, and combinations thereof. Such resins may be prepared by reaction of acrylamide or methacrylamide copolymers with formaldehyde in an alcohol containing solution, or alternatively by the copolymerization or N-alkoxymethylacrylamide or methacrylamide with other suitable monomers. Particularly suitable amine-based crosslinkers include the melamines manufactured by Cytec of West Paterson, New Jersey, such as CYMEL™ 300, 301, 303, 350, 370, 380, 1116 and 1130; benzoguanamine resins such as CYMEL™ 1123 and 1125; glycouril resins CYMEL™ 1170, 1171, and 1172; and urea-based resins BEETLE™ 60, 65 and 80, also available from Cytec, West Paterson, New Jersey. A large number of similar amine-based compounds are commercially available from various suppliers.

Melamines are preferred amine-based cross-linkers. Particularly preferred are alkylolmethyl melamine resins. Such resins are typically ethers such as trialkylolmethyl melamine and hexaalkylolmethyl melamine. The alkyl group may have from 1 to 8 or more carbon atoms but preferably is methyl. Depending upon the reaction conditions and the concentration of formaldehyde, the methyl ethers may react with each other to form more complex units.

Epoxy containing materials useful as cross-linkers are any organic compounds having one or more oxirane rings that are polymerizable by ring opening. Such materials, broadly called epoxides, include, but are not limited to, monomeric epoxy compounds, and polymeric epoxides that may be aliphatic, cycloaliphatic, aromatic or heterocyclic. Preferred epoxy cross-linking materials generally, on average, have at least 2 polymerizable epoxy groups per molecule. The polymeric epoxides include linear polymers having terminal epoxy groups (e.g., diglycidyl ether of a polyoxyalkylene glycol), polymers having skeletal oxirane units (e.g., polybutadiene polyepoxide), and polymers having pendent epoxy groups (e.g., glycidyl methacrylate polymer of copolymer). The epoxides may be pure compounds but are generally mixtures containing one, two or more epoxy groups per molecule.

Useful epoxy-containing materials may vary from low molecular weight monomeric materials and oligomers to relatively high molecular weight polymers and may vary greatly in the nature of their backbone and substituent groups. For example, the backbone may be of any type and substituent groups may be any group free of any substituents reactive with an oxirane ring at room temperature. Suitable substituents include, but are not limited to halogens, ester groups, ethers, sulfonate groups, siloxane groups nitro groups, phosphate groups, and-the like.

Particularly useful epoxy containing materials include glycidyl ethers. Examples are glycidyl ethers of polyhydric phenols obtained by reacting a polyhydric phenol with an excess of chlorohydrin such as epichlorohydrin (e.g., diglycidyl ether of 2,2-bis-(2,3-epoxypropoxyphenol)propane). Such glycidyl ethers include bisphenol A epoxides, such as bisphenol A ethoxylated diepoxide. Further examples of such epoxides are described in U.S. Pat. No. 3,018,262, the entire disclosure of which is hereby incorporated herein by reference.

Suitable epoxides include, but are not limited to, epiclorohydrin, glycidol, glycidylmethacrylate, the glycidyl ether of p-tertiarybutylphenol (e.g., those available under the trade name EPI-REZ® 5014 from Celanese); diglycidyl ether of bisphenol A (e.g., available under the trade designations EPON® 828, EPON® 1004, EPON® 1010 from Shell Chemical Co., and DER-331®, DER-332®, and DER-334® from Dow Chemical Co.), vinylcyclohexane dioxide (e.g., ERL-4206® from Union Carbide Corp.), 3,4-epoxy-6-methyl-cyclohexylmethyl-3,4-epoxy-6-methylcyclohexene carboxylate (e.g., ERL-4201® from Union Carbide Corp.), bis(3,4-epoxy-6-methylcyclohexylmethyl)adipate (e.g., ERL-4289® from Union Carbide Corp.), bis(2,3-epoxycyclopentyl) ether (e.g., ERL-0400® from Union Carbide Corp.), aliphatic epoxy modified with polypropylene glycol (e.g., ERL-4050® and ERL-4269® from Union Carbide Corp.), dipentene dioxide, flame retardant epoxy resins (e.g., DER-580®, a brominated bisphenol type epoxy resin available from Dow Chemical Co.), 1,4-butanediol diglycidyl ether of phenolformaldehyde novolak (e.g., DEN-431® and DEN-438® from Dow Chemical Co.) and resorcinol diglycidyl ether (e.g., KOPOXITE® from Koppers Company, Inc.).

Compounds containing at least two vinyl ether groups include, but are not limited to, divinyl ethers of aliphatic, cycloaliphatic, aromatic or araliphatic diols. Examples of such materials include divinyl ethers of aliphatic diols having from 1 to 12 carbon atoms, polyethylene glycols, propylene glycols, polybutylene glycols, dimethylcyclohexanes, and the like. Particularly useful compounds having at least two vinyl ether groups include divinyl ethers of ethylene glycol, trimethylene-1,3-diol, diethylene glycol, triethylene glycol, dipropylene glycol, tripropylene glycol, resorcinol, bisphenol A, and the like.

Suitable allyl substituted aromatic compounds useful as cross-linker are compounds containing one or more allyl substituents, that is, the aromatic compound is substituted at one or more ring positions by the allylic carbon of an alkylene group. Suitable allyl aromatics include allyl phenyl compounds, such as an allyl phenol. An allyl phenol cross-linker can be a monomer or a polymer that contains one or more phenol units where the phenol units are substituted at one or more ring positions by an allylic carbon of an alkylene group. Typically the alkylene substituent(s) is propenyl, i.e., the phenol has one or more propenyl substituents. Preferred allyl phenols include a polycondensate of phenol and hydroxybenzaldehyde and an allylhalide such as allylchloride. A number of suitable allyl phenols are commercially available, for example the allyl phenol sold under the trade name THERMAX SH-150AR® by Kennedy and Klim, Inc. (Little Silver, N.J.). Allyl phenyl compounds including allyl phenols are also described in U.S. Pat. No. 4,987,264, the entire disclosure of which is hereby incorporated herein by reference.

Particularly suitable organic cross-linking agents include agents containing one or more methoxymethyl groups, such as methoxmethyl-substituted melamines and methoxymethyl-substituted glycourils. Hexamethoxymethylmelamine is a preferred methoxymethyl-substituted melamine. It is further preferred that one or more of the hydrogens of the organic cross-linking agent, and more preferably one or more of the methyl hydrogens in the methoxymethyl substituent, is substituted with a halogen, preferably fluorine. Thus, preferred cross-linkers include compounds containing one or more methoxyfluoromethyl and/or methoxydifluoromethyl substituents. Exemplary preferred fluorinated cross-linking agents include methoxyfluoromethyl- and methoxyfluoromethyl-substituted melamines and glycourils, such as hexamethoxyfluoromethylmelamine and hexamethoxydifluoromethylamine. Also suitable are fluorinated epoxy cross-linking agents.

The polymer layers of the present invention may contain only a single type of cross-linker or may contain two or more different cross-linkers. Any combination of two or more cross-linkers disclosed above may be employed. A preferred combination for novolak resins and poly(vinylphenols) is an amine containing compound and an epoxy containing compound.

In another embodiment of the present invention, at least one of the polymer layers is an inorganic polymer. Preferably only one of the polymer layers is an inorganic polymer. Inorganic polymers within the scope of the present invention are derived from oxides such as metal alkoxides and other alkoxides having a general formula:

M(OR)ₙ

where M is a metal, boron, phosphorous or silicon, R is a linear or branched alkyl group and n is an integer of 1 or greater. Preferably R is an alkyl group of from 1 to 4 carbon atoms. Preferably n is an integer of from 2 to 6. Examples of alkoxides having the above general formula include, but are not limited to, Si(OCH₃)₄, Si(OC₂H₅)₄, Si(OC₃H₇)₄, Si(OC₄H₉)₄, Si(OC₂H₅)₃, Al(OCH₃)₃, Al(OC₂H₅)₃, Al(OC₄H₉)₃, Al(iso-OC₃H₇)₃, Ti(OC₃H₇)₄, Zr(OC₃H₇)₄, Zr(OC₂H₅)₄, Ti(OC₃H₇)₄, Y(OC₃H₇)₃, Y(OC₄H₉)₃, Fe(OC₂H₅)₃, Fe(OC₃H₇)₃, Fe(OC₄H₉)₃, Nb(OCH₃)₅, Nb(OC₂H₅)₅, Nb(OC₃H₇)₅, Ta(OC₃H₇)₅, Ta(OC₄H₉)₄, Ti(OC₃H₇)₄, V(OC₄H₅)₃, V(OC₄H₉)₃, Zn(OC₂H₅)₂, B(OCH₃)₃, Ga(OC₂H₅)₃, Ge(OC₂H₅)₄, Pb(OCH₃)₃, P(OCH₃)₃, V(OC₂H₅)₃, W(OC₂H₅)₆, Nd(OC₂H₅)₃, LiOCH₃, NaOCH₃, and Ca(OCH₃)₂.

Also, alkoxides within the scope of the present invention may be anionic. Such anionic alkoxides have a general formula:

M[M₁(OR)ₙ]ₘ

where M and R are defined as above, and M₁ is a metal but different from M in the above formula, and m is an integer of 1 or greater. Preferably, m is an integer of from 2 to 3. Such anionic alkoxides include, but are not limited to, La[Al(OR)₄]₃, La[Al(iso-OC₃H₇)₄]₃, Mg[Al(iso-OC₃H₇)₄]₂, Mg[Al(sec-OC₄H₉)₄]₂, Ni[Al(iso-OC₃H₇)₄]₃, (C₃H₇O)₂Zr[Al(OC₃H₇)₄]₂, and Ba[Zr₂(OC₂H₅)₉]₂.

In addition to the above described alkoxides, inorganic polymers within the scope of the present invention may be prepared from metal complex compounds such as iron tris(acetyl acetonate), cobalt bis(acetyl acetonate), nickel bis(acetyl acetonate), copper bis(acetyl acetonate), and the like.

Precursors described above are joined together by a M-O-M bond to form inorganic polymers. Inorganic polymers within the scope of the present invention may be prepared by any suitable method known in the art. One such method is the sol-gel method which is known and practiced in the art. Another suitable method is the decarbonizing gel method disclosed in U.S. 5,234,556, the entire disclosure of which is hereby incorporated herein by reference.

In addition to tuning the permittivity of a dielectric and a capacitance of a capacitor, the polymer layers also support and stabilize the dielectric structure such that the dielectric may be prepared separately from the substrate on which it is to be applied. For example, dielectrics and capacitors within the scope of the present invention may be manufactured separately from the processes involved in the manufacture of a printed wiring board or similar apparatus employed in electronic devices. Thus, dielectrics may be prepared in bulk such as in a sheet. Multiple sheets may be prepared with each sheet having a different permittivity value. Because the polymer layers provide structural support for the entire dielectric structure, the sheets may have a range of thicknesses. Dielectric thicknesses range from about 5 µm to about 1000 µm, preferably from about 50 µm to about 500 µm. Core thicknesses range from about 0.05 µm to about 900 µm, preferably from about 0.5 µm to about 250 µm.

Polymer layer thickness ranges are from about 2.0 µm to about 500 µm, preferably from about 20 µm to about 200 µm. The polymer layers have a tensile strength of from about 0.025 psi to about 0.5 psi, preferably from about 0.075 psi to about 0.25psi. Polymer stretch ranges from about 0.25% elongation to about 2.75% elongation, preferably from about 0.75% elongation to about 1.50% elongation. Advantageously, such properties permit the dielectric compositions of the present invention to be rolled upon themselves such as in the form of a scroll without the dielectric compositions cracking or tearing. Such properties enable sheets of multiple length and width of dielectric material to be readily and conveniently stored in bulk. Dielectric laminate sheets may be prepared in bulk having any suitable length or width for convenient storage and handling. For example, a bulk sheet may range from about 500 cm x about 1000 cm, preferably from about 200 cm x about 500 cm. Such bulk sheets having the aforementioned dimensions may be readily prepared with laminating apparatus such that the bulk sheets may be rolled or shaped for bulk storage. Conventional dry film apparatus may be employed to roll the sheets for bulk storage.

Advantageously, aliquots or coupon patches of dielectric laminate may be punched or cut from the bulk sheets having any suitable desired dimensions, i.e., length and width, and shape, and placed on a substrate such as a printed wiring board. For example, an aliquot may be rectangular in shape or circular in the shape. Rectangular aliquots, for example, may have dimensions of from about 1000µm x about 1000µm or about 500µm x about 500µm. Circular shaped aliquots, for example, may have a radius of from about 500µm to about 1000µm. Any suitable punch device or cutting device used to shape and cut polymer material in the art may be employed. One means by which the polymer laminate may be cut and shaped is by a laser. Suitable lasers include, but are not limited to, Nd:YAG, CO₂ or excimer lasers and the like. Alternatively, an entire sheet of dielectric can cover an entire surface of a substrate or printed wiring board. The dielectric may then be etched with a suitable etchant using masks or tools to form a desired pattern.

Another embodiment of the present invention is a capacitor composed of a dielectric laminate having a core material between two layers of lower permittivity material. Figure 2 illustrates a capacitor 18 of the present invention. A core dielectric layer 20 is bonded between a bottom support polymer dielectric layer 22 and a top support polymer dielectric layer 24. Both the bottom support polymer dielectric layer 22 and the top support polymer dielectric layer 24 have permittivity values lower than the core dielectric layer 20. A conductive metal bottom electrode 26 and a conductive top metal electrode 28 are bonded to their respective polymer layers to form a capacitor having a specific capacitance. Capacitance is defined by the following equation:

C = P (A/d)

"C" is total capacitance of a capacitor (farads, micro-farads, nano-farads or pico-farads), "A" is the surface area of an electrode and "d" is the distance between the two electrodes of the capacitor. "P" is the permittivity or dielectric constant of the dielectric material between the two electrodes. Thus, capacitance of a capacitor may be tuned by altering anyone of the parameters "A", "d", or "P". Advantageously, a core dielectric material between two polymer layers of lower permittivity permits fine tuning of the permittivity "P" of a dielectric composition. Both the dielectric material employed as well as the thickness of the dielectric material may be altered to tune the permittivity of the dielectric. When the dielectric of the core material is substantially higher than the polymer material, the permittivity of the dielectric is substantially the same as or is the same as the core material. Thus an accurate value for the permittivity of a given dielectric can be determined. By altering the thickness of the polymer layers and keeping the thickness of the core dielectric constant, the capacitance "C" of a capacitor may be accurately tuned to a specific value without altering the permittivity of the dielectric. Accordingly, the capacitance "C" also may be fine tuned by fine tuning the permittivity of the dielectric. Thus thin film capacitors with accurate capacitance values may be prepared.

Figure 3 illustrates another embodiment of the present invention. A capacitor 30 is composed of a core dielectric 32 composed of a layer of one type of high permittivity dielectric material 34 bonded to a second type of high permittivity material 36 with a permittivity different than that of the first high permittivity material. The core dielectric 32 is bonded to a bottom support polymer layer 38 and a top support polymer layer 40. Both polymer layers have permittivity values less than the core dielectric materials. A conductive top metal layer 42 and a conductive bottom metal layer 44 are bonded to their respective polymer layers. By changing the number or layers and the type of core material, the permittivity of the dielectric can be accurately changed to a desired value. Thus, given values for both "A" and "d" of the above equation an accurate value for the capacitance can be determined. Capacitance may be further tuned by changing the thickness of either the bottom support polymer dielectric 38, or by changing the thickness of the top support polymer layer 40, or both layers. Changing the thickness of the polymer layers 38 and 40 does not alter the permittivity value of the dielectric. Accordingly, capacitance of capacitor 30 can be accurately tuned.

Any suitable metal that may be employed in a capacitor may be employed as conductive layers of the capacitor of the present invention. Suitable metals include, but are not limited to, copper, nickel, tin, aluminum, gold, silver, platinum, palladium, tungsten, iron, niobium, molybdenum, titanium, nickel/chromium alloy and iron/nickel/chromium alloy, and the like. Preferred metals are copper and nickel. Metal layers may range in thickness of from about 20 nanometers (nm) to about 1 mm, preferably from about 100 nm to about 50 µm. Most preferably, the metal layers have a thickness of from about 500 nm to about 5 µm. Capacitors of the present invention have capacitance density values of less than about 1000 µF/cm². Because the dielectric and conductive metal layers of the capacitors of the present invention may have thicknesses down to the nanometer range, capacitors may have capacitance values in micro-farad (µF), nano-farad (nF) and down to the pica-farad (pF) ranges. Such thin film capacitors of the present invention may have capacitance density values of preferably from about 500 µF/cm² down to about 100 pF/cm², more preferably from about 50 nF/cm² down to about 500 pF/cm². Permittivity values for dielectrics within the scope of the present invention are greater than 1, and may have values of up to about 15000. Typically, permittivity values range from about 10 to about 1000.

The metal layers may be bonded to the polymer layers by any suitable method in the art. Examples of such methods include, but are not limited to, mechanical lamination; depositing a metal on the polymer surfaces such as by electroless deposition; electroless deposition followed by electrolytic deposition; physical vapor deposition (PVD) and chemical vapor deposition (CVD); combustion chemical vapor deposition (CCVD); controlled atmosphere combustion chemical vapor deposition (CACCVD); and the like. Preferred methods for forming a metal layer on a polymer are electroless deposition, and electroless deposition followed by electrolytic deposition.

Polymer layers may be prepared by any suitable method that permits the polymer layers to have a desired thickness for dielectric laminates of the present invention. Examples of suitable methods for forming a polymer layer, include but are not limited to, extrusion, blow molding or solvent casting. Such methods are well known in the polymer art.

Core layers of dielectric material may be coated or laminated to a polymer layer by any suitable method that enables formation of core layers of desired thickness. Such methods include, but are not limited to, CCVD, CACCVD, PVD, CVD, by doctor-blades (as a paste), and the like. Preferably core layers of dielectric materials are coated on a polymer by CCVD, or by CACCVD. Such methods permit dielectric materials to be coated on a polymer down to thicknesses described above. Any suitable apparatus employed for CCVD and CACCVD methods may be employed to practice the present invention.

CCVD is performed under ambient conditions in open atmosphere to produce a film on a substrate. Preferably the film is crystalline, but may be amorphous, depending on the reagent and deposition conditions used. The reagent, or chemically active compound, is dissolved or carried in a solvent, such as a liquid solvent, such as an alkene, alkide or alcohol. The resulting solution is sprayed from a nozzle using oxygen-enriched air as the propellant gas and ignited. A substrate is maintained at or near the flame's end. Flame blow-off may be prevented by use of a hot element such as a small pilot light. The reactants vaporize in the flame and are deposited on the substrate as a film. Resulting films (coatings) have shown extensive preferred orientation in X-ray diffraction patterns, evidencing that CCVD occurred by heterogeneous nucleation and resulting in a film having a preferred orientation. Alternatively, depositions can be performed by feeding solution through a nebulizer, such as a needle bisecting a thin high velocity air stream forming a spray that is ignited and burned. Deposition rates of core materials or metals on a polymer range from about 10 µm/min to about 50 µm/min, preferably from about 20 µm/min to about 35 µm/min. Deposition of a core material on another core material of different permittivity ranges from about 1.0 µm/min to about 100 µm/min.

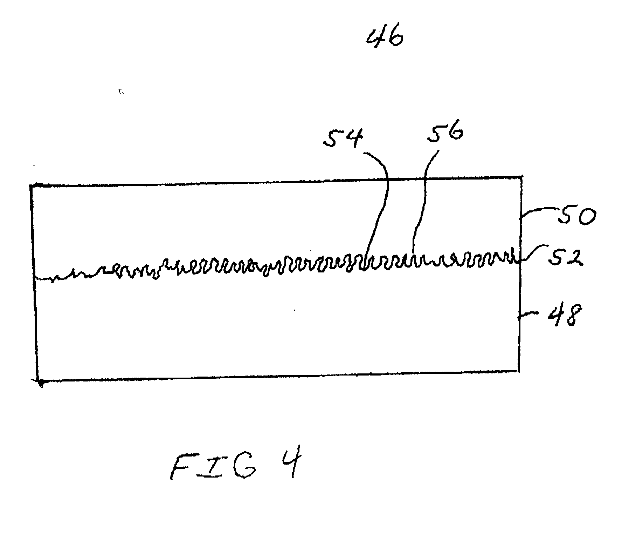

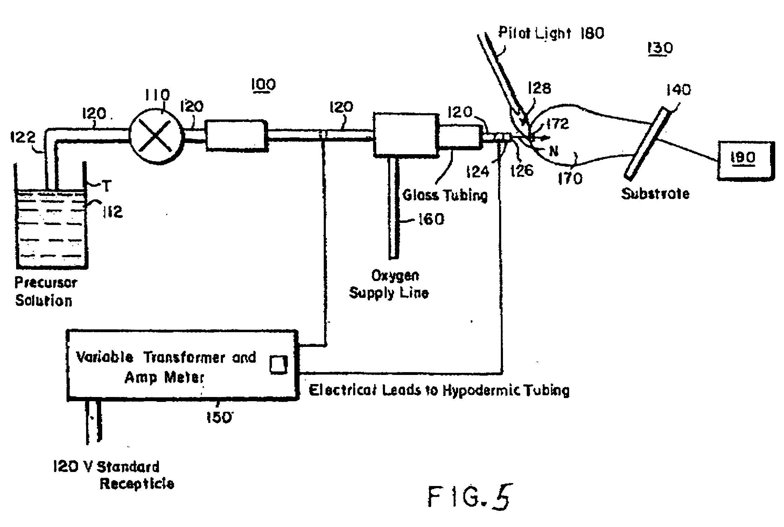

Flame temperature is dependent on the type and quantity of reagent, solvent, fuel and oxidant used, and the substrate shape and material. When the substrate is a polymer such as a condensation polymer, thermoplastic polymer or one of the polymers described above, flame temperatures range from about 100° C to about 1500° C, preferably from about 400° C to about 800° C. When plasma is formed for depositing the coating, plasma temperatures may range from about 800° C to about 2000° C, preferably from about 1100° C to about 1700° C. Polymer substrates are maintained at such relatively low temperatures by a cooling apparatus as described in reference to Figure 5 below. Polymer substrates may be placed on any suitable furniture to support the polymer during coating. An example of such furniture is a silicon carbide plate. Both the silicon carbide plate and the polymer substrate are maintained at about the same temperature during coating to provide ready release of the coated polymer substrate from the silicon carbide furniture. Such temperatures are maintained to prevent the polymer material from melting, charring or otherwise decomposing. Accordingly, a high T_{g} polymer or a polymer with aromatic content is preferred because such polymers maintain a desired integrity during coating. Preferably when a core material or metal is deposited on a polymer substrate the core material or metal melts the polymer sufficiently to provide a textured polymer surface. A strong bond between the polymer material and the deposited core material or metal is formed upon cooling the combined materials to below about 100° C. Preferably the combined materials are cooled to from about 15° C to about 35° C. Advantageously, the textured interface provides a high integrity bond such that a dielectric with such an interface can be rolled onto itself without the layers de-laminating or cracking. Figure 4 illustrates a dielectric 46 with a polymer layer 48 coated with a CCVD deposited core material 50. The polymer layer 48 is joined to the CCVD deposited core material 50 at a textured interface 52. The textured interface 52 has troughs 54 and peaks 56 that are formed when the CCVD core material 50 is deposited on the polymer layer 48. The troughs 54 and peaks 56 form a lock-key interface to form a high integrity bond between the two layers when the dielectric 46 is cooled.

When a core material is coated on another core material or a metal is coated on a core material by CCVD, flame temperatures are between about 300° C to about 2800° C. Flame temperatures and core material substrate temperatures are dependent on the type and quantity of reagent, solvent, fuel and oxidant used, and the substrate shape and core material. Such conditions for coating a core material can be readily determined by one of skill in the art with minor experimentation when presented with the specific reagent, solvent, fuel, oxidant and other components and conditions for deposition. When a core material is laminated to a polymer layer, the conditions for coating the core material with another core material or metal layer are the conditions described for coating a polymer layer with a core material. The laminate of the core material and the polymer is kept cool enough such that the polymer does not begin to melt during coating of the core material. Thus, flame temperatures and substrate temperatures are within the ranges described above for polymers. Because flames can exist over a wide pressure range, CCVD can be accomplished at a pressure range of from about 10 torr to about 10,000 torr.

Suitable reagents or chemical precursors for core materials or metal layers include, but are not limited to, platinum-acetylacetonate (Pt(CR₃COCHCOCH₃)₂) (in toluene/methanol), platinum-(HFAC₂), diphenyl-(1,5-cyclooctadiene) Platinum (II) (Pt(COD) in toluene-propane) and platinum nitrate (in aqueous ammonium hydroxide solution); magnesium naphthenate, magnesium 2-ethylhexanoate, magnesium nitrate, and magnesium-2,4-pentadionate; tetraethoxysilane, tetramethylsilane, disilicic acid and metasilicic acid; nickel nitrate (in aqueous ammonium hydroxide), nickel-acetylacetonate, nickel-2-ethylhexonate, nickel-napthenol and nickel-dicarbonyl; aluminum nitrate, aluminum acetylacetonate, triethyl aluminum, aluminum-sbutoxide, aluminum-i-propoxide, and aluminum-2-ethylhexonate; zirconium 2-ethylhexonate, zirconium n-butoxide, zirconium-acetylacetonate, zirconium-n-propanol, and zirconium-nitrate; barium 2-ethylhexanoate, barium nitrate, and barium acetylacetonate; niobium ethoxide; titanium (IV) i-propoxide, titanium (IV) acetylacetonate, titanium-n-butoxide, and titanium oxide bis(acetylacetonate); yttrium nitride, and yttrium napthenoate; strontium nitrate, and strontium 2-ethylhexanoate; cobalt naphthenate and cobalt nitrate; chlorotriethylphosphine gold (I) and chlorotriphenylphosphine gold (I); trimethyl borate, and B-trimethoxyboroxine; copper (2-ethylhexonate)₂, copper nitrate and copper acetylacetonate; palladium nitrate (in aqueous ammonium hydroxide solution), palladium acetylacetonate, and ammonium hexachloropalladium; silver nitrate (in water), silver fluoroacetic acid, and silver-2-ethylhexanoate; cadmium nitrate, and cadmiun-2-ethylhexanoate; niobium (2-ethylnexanoate); molybdenum-dioxide bis (acetylacetonoate); and bismuth nitrate.

Figure 5 illustrates one type of CCVD apparatus 100 that may be employed to deposit a layer of core dielectric material on a polymer layer. Apparatus 100 has a pressure regulating means 110, such as a pump, for pressurizing to a first selected pressure a transport solution T (also called a precursor solution) in a transport solution reservoir 112. The transport solution T contains a suitable carrier having dissolved therein one or more reagents capable of reacting to form a selected material and the means for pressurizing 110 is capable of maintaining the first selected pressure above the corresponding liquid of the transport solution T at the temperature of the transport solution T. A fluid conduit 120 having an input end 122 in fluid connection with the transport solution reservoir 112 and an opposed output end 124 having an outlet port 126 orientated to direct the fluid in the conduit 120 into a region 130 of a second selected pressure below the first selected pressure and in the direction of the substrate 140, the outlet port 126 further contains means 128 for nebulizing a solution to form a nebulized solution spray N, a temperature regulating means 150 positioned in thermal connection with the output end 124 of the fluid conduit 120 for regulating the temperature of the solution at the output end 124 within 50° C above or below the supercritical temperature of the solution, a gas supply means 160 for admixing one or more gases (e.g., oxygen) (not shown) into the nebulized solution spray N to form a reactable spray, an energy source 170 at a selected energization point 172 for reacting the reactable spray such that the energy source 170 provides sufficient energy to react the reactable spray in the region 130 of the second selected pressure thereby coating a substrate 140. The reactable spray is composed of a combustible spray having a combustible spray velocity and where the combustable spray velocity is greater than the flame speed of the flame source at the ignition point 172 and further containing one or more ignition assistance means 180 for igniting the combustible spray. Each of the one or more ignition assistance means 180 contains a pilot light.

The energy source 170 may be a flame source and the selected energization point 172 is an ignition point. The energy source also may be a plasma torch.

The apparatus 100 also provides a substrate cooling means 190 for cooling the substrate 140. The substrate cooling means 190 is a means for directing water onto the substrate 140. Many other suitable cooling means may be employed. Another suitable cooling means is a gas (air) shower, flow or curtain. Such means are well known to those of skill in the art.

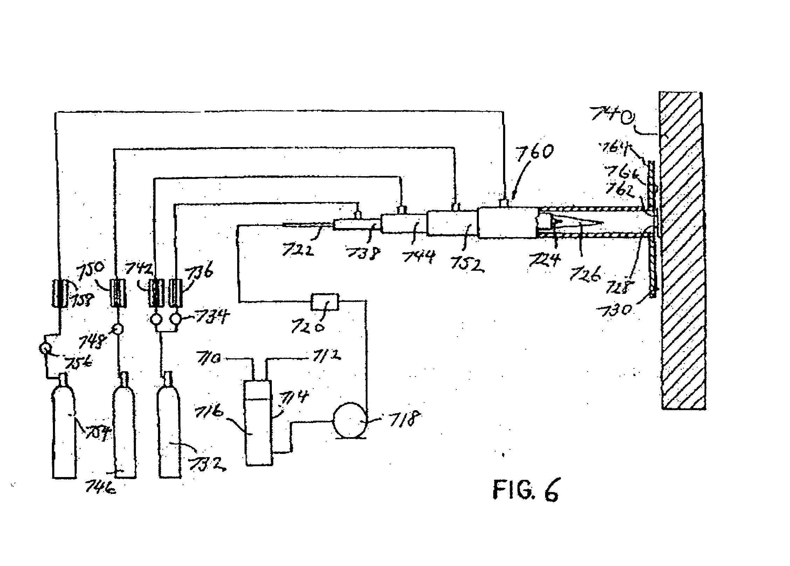

Figure 6 illustrates an apparatus for CACCVD. A coating precursor 710 is mixed with a liquid media 712 in a forming zone 714, containing a mixing or holding tank 716. The precursor and liquid media 712 are formed into a flowing stream that is pressurized by pump 718, filtered by filter 720 and fed through conduit 722 to an atomization zone 724, from which it flows successively through reaction zone 726, deposition zone 728 and barrier zone 730. A true solution need not be formed from mixing the coating precursor 710 with the liquid media 712, provided the coating precursor is sufficiently finely divided in the liquid media. However, formation of a solution is preferred, since such produces a more homogeneous coating.

The flowing stream is atomized as it passes into the atomization zone 724. Atomization is effected by discharging a high velocity atomizing gas stream surrounding and directly adjacent the flowing stream as it discharges from conduit 722. The atomizing gas is fed from gas cylinder 732, through regulating valve 734, flowmeter 736 and into conduit 738. Conduit 738 extends concentrically with conduit 722 to the atomization zone where both conduits end allowing the high-velocity atomizing gas to contact the flowing liquid stream thereby causing it to atomize into a stream of fine particles suspended in the surrounding gas/vapors. The stream flows into the reaction zone 726 where the liquid media vaporizes and the coating precursor reacts to form a reacted coating precursor. The flowing stream/plasma passes to deposition zone 728 where the reacted coating precursor contacts the substrate 740 depositing the coating thereon.

The flowing stream may be atomized by injecting the atomizing gas stream directly at the stream of liquid media/coating precursor as it exits conduit 722. Alternatively, atomization can be accomplished by directing ultrasonic or similar energy at the liquid stream as it exits conduit 722.

The vaporization of the liquid media and reaction of the coating precursor require substantial energy input to the flowing stream before leaving the reaction zone. The energy input can be accomplished by the combustion of a fuel and an oxidizer in direct contact with the flowing stream as it passes through the reaction zone. The fuel, hydrogen, is fed from the gas cylinder 732, through a regulating valve, flowmeter 742 and into conduit 744. The oxidizer, oxygen, is fed from gas cylinder 746, through regulating valve 748 and flowmeter 750 to conduit 752. Conduit 752 extends about and concentric with conduit 744, which extends with and concentrically about conduits 722 and 738. Upon exiting their respective conduits, the hydrogen and oxygen combust creating combustion products that mix with the atomized liquid media and coating precursor in the reaction zone 726, thereby heating and causing vaporization of the liquid media and reaction of the coating precursor.

A curtain of a flowing inert gas provided around at least the initial portion of the reaction zone isolates the reactive materials present in the apparatus located in proximity to the reaction zone. An inert gas, such as argon, is fed from inert gas cylinder 754, through regulating valve 756 and flowmeter 758 to conduit 760. Conduit 760 extends about and concentric with conduit 752. Conduit 760 extends beyond the end of the other conduits 722, 738, 744 and 752, extending close to the substrate where it functions with the substrate 740 to define a deposition zone 728 where coating 762 is deposited on the substrate in the shape of a cross-section of conduit 760. As the inert gas flows past the end of conduit 752, it initially forms a flowing curtain that extends about the reaction zone, shielding the reactive components therein from conduit 760. As it progresses down the conduit 760, the inert gas mixes with the gas/plasma from the reaction zone and becomes part of the flowing stream directed to the deposition zone 728.

In the deposition zone 728, the reacted coating precursor deposits coating 762 on the substrate 740. The remainder of the flowing stream flows from the deposition zone through a barrier zone 730 to discharge into the surrounding, or ambient, atmosphere. The barrier zone 730 functions to prevent contamination of the deposition zone by components of the ambient atmosphere. The high velocity of the flowing stream as it passes through the barrier zone 730 is a characteristic feature of the zone.

A collar 764 is attached to and extends perpendicularly outward form the end of the conduit 760 adjacent deposition zone 728. The barrier zone 730 is defined between the collar 764 and the substrate 740. The collar is shaped to provide a conforming surface 766 deployed close to the surface of the substrate where a relatively small clearance is provided for the exhaust of gases passing from the deposition zone to the ambient atmosphere. The clearance established by the conforming surface 764 of the collar and the substrate is sufficiently small that the exhaust gases are required to achieve the velocity of the barrier zone for at least a portion of their passage between the collar and the substrate. The conforming surface 764 of the collar 762 is shaped to lie essentially parallel to the surface of the substrate 740.

In operation, the collar 764 is about 1 cm or less from the surface of the substrate 740. Preferably the facing surfaces of the collar and the substrate are between about 2 mm to about 5 mm apart. Spacing devices, such as three fixed or adjustable pins (not shown), may be provided on the collar to assist in maintaining the proper distance between the collar and the substrate.

Temperature conditions for the substrate are the same as for CCVD methods. As discussed above CACCVD is preferably employed where oxygen inert environments are desired during deposition. CVD and PVD also may be employed to form the dielectric and capacitor of the present invention. As with CCVD and CACCVD methods the temperature of the polymer is kept within the temperature ranges disclosed above to prevent undesired melting of the polymer.

Dielectric laminates of the present invention may be laminated on a substrate such as a printed wiring board such that the dielectric laminate serves as a pre-preg for the surface of the board. Dielectric laminates of the present invention may be laminated to a substrate by any suitable method known in the art. Examples of such methods include, but are not limited to, hotroll lamination, hot-press lamination and the like. When a dielectric laminate is laminated to a metal coated PWB, preferably the metal surface has been textured such that the polymer layer of the dielectric forms a high integrity bond with the PWB. Many methods of texturing a PWB surface are known in the art and a specific method of texturing a PWB metal surface is left to the discretion of each worker in the art.

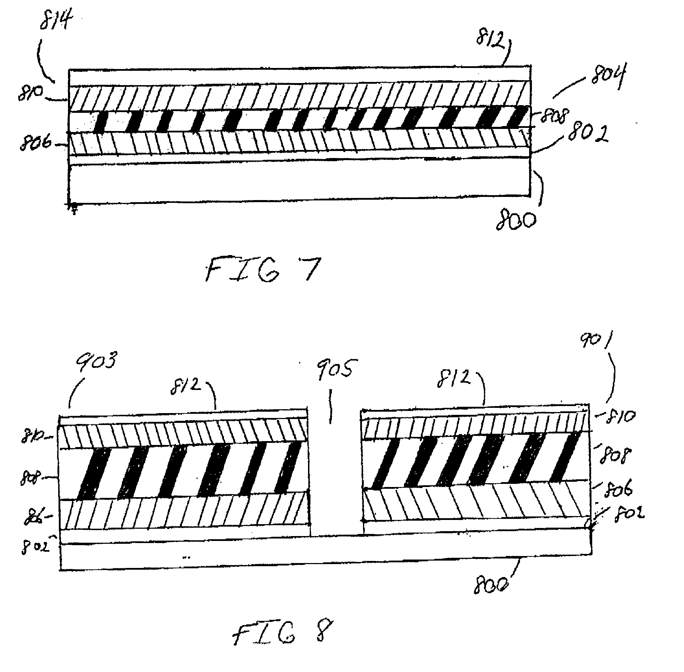

Figures 7 and 8 illustrate a cross-section of a PWB with a capacitor of the present invention. PWB 800 is a FR-4 epoxy/glass board with a copper metal clad layer 802. Dielectric laminate 804 was prepared as a separate sheet, and laminated to the copper metal clad layer 802 by mechanical lamination to form the pre-preg of the PWB. Dielectric laminate 804 is composed of polymer layer 806, core layer 808 and polymer layer 810. Copper metal layer 812 can be deposited by electroless metal deposition to form capacitor 814. Thus capacitor 814 is composed of copper metal layer 802, dielectric laminate 804 and copper metal layer 812. A mask having a desired pattern can be placed over the PWB and the capacitor 814 can be etched to form multiple capacitors of different desired shapes and sizes. By altering the shape and/or size of a capacitor, the area "A" of the electrode changes and the capacitance also changes. Thus capacitor capacitance may be altered as desired by an etching process.

Figure 8 illustrates PWB 800 with discrete capacitors 901 and 903 that were formed by etching the surface of capacitor 814 of Figure 7. The etching process produced via 905 that separates capacitor 901 from 903. Via 905 may be metalized with copper by electroless platting to provide for a means of electrical connection between PWB 800 and another PWB that may be laminated over it.

Alternatively, when the dielectric has a photosensitve polymer layer, a patterned mask may be placed on the polymer, the polymer layer may be exposed to an appropriate wavelength of light and the polymer layer may be developed and etched to a desired pattern followed by plating the developed polymer. Any suitable developing and etching method may be employed. Many such suitable methods are well known in the art. Each worker in the art may choose a specific method based on the specific polymer employed and the worker's preference. Advantageously, a multiple board array may be prepared where each board has a specifically patterned capacitor arrangement with capacitors tuned to specific capacitance values. Such PWBs may be prepared as single bulk boards with specific capacitor patterns and specific capacitance values, or the boards may be assembled as multiple board laminates prior to sending to the consumer.

As discussed above dielectric laminates of the present invention may be cut into aliquots or coupons with a desired size and permittivity. Such aliquots may be placed at desired sites on a substrate such as a PWB to form a PWB package with multiple permittivity values. Aliquots may be placed on a PWB by any suitable method in the art. Conventional lamination techniques may be employed for placing aliquots on a PWB. Each aliquot or coupon may be etched, or plated and then etched as the pre-preg assembly described above.

Advantageously, the capacitors of the present invention may be employed as embedded capacitors to reduce surface structure on PWB surfaces. Also, the capacitors of the present invention may be thin film capacitors, and function as decoupling capacitors to significantly reduce unwanted noise in high current power distribution systems. Capacitors of the present invention may be employed in digital computers, telecommunication modules, for AC ripple filtering in DC power supplies, and the like.

All numerical ranges within the present application are inclusive and combinable.

The following example is intended to further illustrate the present invention and is not intended to limit the scope of the invention.

### Example

A 500 cm x 500cm sheet of 25 µm thick Dyna Via® (epoxy dielectric dry film obtainable from Shipley Company, Marlborough, MA) is blow molded. The Dyna Via® is employed as a substrate for CCVD deposition of barium strontium titanate (BST). The Dyna Via® is placed on silicon carbide furniture to support the polymer during deposition. The apparatus as illustrated in Figure 6 is employed for CCVD deposition. The precursor solution was composed of, by weight percentage, 0.79% barium bis(2-ethylhexanoate), 0.14% strontium bis(2-ethylhexanoate), 0.23% titanium diisopropoxide-bis(acetylacetonate), 17.4% toluene and 81.5% propane. During deposition the solution flow rate, oxygen flow rate and cooling airflow rate are kept constant. The flow rate for the solution is about 3.0 ml/min and for the oxygen about 3500 ml/min at about 65 psi. The cooling is at a temperature of about -2° C and the airflow rate is at about 5 L/min at about 20 psi. The cooling air is directed at the Dyna Via® substrate with a copper tube whose end is positioned above the substrate. Deposition is performed at about 500° C flame temperature. Flame temperature is measured with a Type-K thermocouple. After deposition of the strontium oxide layer, a second Dyna Via® layer having equal dimensions of the first polymer layer is laminated to the strontium oxide layer.

The dielectric is then laminated to copper cladding on a FR-4 epoxy/glass printed wiring board. The exposed Dyna Via® is then plated with a copper layer of about 500 µm by electroless deposition. The copper layer is etched to a desired pattern to form multiple capacitors on the printed wiring board.

## Claims

1. A dielectric laminate comprising a core layer bonded to a first polymer layer and to a second polymer layer, the core layer has a permittivity higher than the first polymer layer and the second polymer layer, the first and second polymer layers provide a means such that the dielectric laminate is self-supporting.

2. The dielectric laminate of claim 1, wherein the core layer comprises a carbon material, a ceramic material, or mixtures thereof.

3. The dielectric laminate of claim 1, wherein the first and second polymer layers comprise thermoplastic polymers, thermosetting polymers, addition polymers, condensation polymers or mixtures thereof.

4. The dielectric laminate of claim 1, wherein the polymer is an inorganic polymer and is derived from metal complex compounds, compounds having the general formula M(OR)ₙ, or compounds having the general formula M[M₁(OR)ₙ]ₘ, where M is a metal, boron, phosphorous or silicon, M₁ is a metal different from M, R is a linear or branched alkyl group, n is an integer of 1 or greater, and m is an integer of 1 or greater.

5. The dielectric laminate of claim 1, wherein the dielectric laminate has a thickness of from about 5 µm to about 1000µm.

6. The dielectric laminate of claim 1, wherein the core layer has a thickness of from about 0.05 µm to about 900 µm.

7. The dielectric laminate of claim 1, further comprising a first metal layer adjacent to the first polymer layer, and a second metal layer adjacent to the second polymer layer to form a capacitor.

8. A method for forming a self-supporting dielectric comprising: depositing on a first polymer layer a core dielectric material; and depositing a second polymer layer on a surface of the core dielectric opposite the first polymer layer to form the self-supporting dielectric, the core has a permittivity higher than the first and the second polymer layers.

9. The method of claim 8, wherein the core dielectric is deposited on the first polymer layer by combustion chemical vapor deposition, or controlled atmosphere combustion chemical vapor deposition.

10. The method of claim 8, wherein the first and second polymer layers comprise thermoplastic polymers, thermosetting polymers, addition polymers, condensation polymers, or copolymers, grafts, blends or mixtures thereof.

11. The method of claim 8, wherein the first or second polymer layer is an inorganic polymer derived from metal complex compounds, a compound having a general formula M(OR)ₙ, or M[M₁(OR)ₙ]ₘ, where M is a metal, boron, phosphorous or silicon, M₁is a metal different than M, R is a linear or branched alkyl group, n is an integer of 1 or greater, and m is an integer of 1 or greater.
